# EUROPÄISCHE PATENTSCHRIFT

(11) **EP 3 993 190 B1**
(45) Veröffentlichungstag und Bekanntmachung des Hinweises auf die Patenterteilung: **03.12.2025**
(21) Anmeldenummer: 21203711.3
(22) Anmeldetag: 20.10.2021
(51) Int. Cl.: H05K 7/14, H02B 1/20, H02B 1/052, G05B 19/02

(54) **TRAGSCHIENEN-BUSANORDNUNG MIT AUTOMATISCHER BUSADRESSIERUNG**
SUPPORT RAIL BUS ASSEMBLY WITH AUTOMATIC BUS ADDRESSING
AGENCEMENT DE BUS À RAIL DE SUPPORT AVEC ADRESSAGE AUTOMATIQUE DE BUS

(30) Priorität: 03.11.2020 DE 102020128847
(43) Veröffentlichungstag der Anmeldung: 04.05.2022
(73) Patentinhaber: Bender GmbH & Co. KG, 35305 Grünberg (DE)
(72) Erfinder: BECKER, Matthias, 36325 Feldatal (DE); SCHÄFER, Oliver, 35305 Grünberg (DE); MACHT, Burkhard, 35410 Hungen (DE); PRINZ-WEINEL, Michael, 63691 Ranstadt (DE)
(74) Vertreter: advotec.

(56) Entgegenhaltungen:
- EP-A2- 2 053 697
- EP-A2- 2 964 005
- DE-A1- 102010 016 865
- DE-A1- 102019 203 521
- DE-C1- 19 838 493

## Beschreibung

Die Erfindung betrifft eine Tragschienen-Busanordnung, bestehend aus einer Anzahl von n mechanisch zusammenhängenden und elektrisch über Busleiterbahnen verbundenen in einer Tragschiene nebeneinander an Einbaupositionen i (1≤i≤n) installierbaren Busleiterplatten-Abschnitten, die jeweils k Kontaktelemente zur Kontaktierung eines an der jeweiligen Einbauposition i auf die Tragschiene aufgesteckten Gerätes aufweisen.

Zur Befestigung von elektrische Betriebsmitteln wie beispielsweise Fehlerstrom-Schutzeinrichtungen, Relais oder Sicherungsautomaten in Verteilerkästen oder Schaltschränken für elektrische Anlagen werden Tragschienen verwendet, auf die die jeweiligen Gehäuse der elektrischen Betriebsmittel (Geräte) seitlich aufgeschoben oder aufgesteckt und arretiert werden. Um eine aufwendige manuelle Verdrahtung der Geräte zu umgehen, sind im Handel Tragschienen-Bussysteme verfügbar, die die einzelnen Geräte als Tragschienen-Busteilnehmer elektrisch zur Energieversorgung, zur Datenkommunikation und zur Signalisierung miteinander verbinden, ohne dass eine Einzelverdrahtung durchgeführt werden muss.

So ist beispielsweise aus dem Stand der Technik das 16-polige Tragschienen-Busverbindersystem HBUS der Firma PHOENIX CONTACT (www.phoenixkontakt.com) bekannt. Das Busverbindersystem HBUS beruht auf Tragschienen-Busverbinderelementen, die in die Tragschiene (DIN-C-Schiene) eingesetzt und mit dieser verrastet wird. Dabei werden die Tragschienen-Busverbinder durch seitliches Zusammenschieben über 16-polige Stecker und Buchsenleisten miteinander elektrisch kontaktiert. Die Gerätegehäuse können dann auf die Tragschiene und somit gleichzeitig auf die Tragschienen-Busverbinder aufgeschnappt und elektrisch kontaktiert werden.

Weiterhin ist aus dem Stand der Technik ein Bussystem der Firma E. Dold & Söhne KG unter der Bezeichnung "IN-RAIL-BUS" ein Bussystem zur Integration in eine Standard-Tragschiene (DIN-C-Schiene) bekannt. Bei diesem System wird ein Trägerprofil aus Kunststoff mit vormontierter Busleiterplatte in die Tragschiene eingelegt. Auf der Busleiterplatte sind parallel verlaufende Leiterbahnen aufgebracht, die bei Aufschnappen der Gerätegehäuse auf die Tragschiene über Kontaktfederblöcke kontaktiert werden. Die Trägerprofile und Leiterplatten können in der Länge gekürzt werden und somit an die entsprechenden Gerätegehäuse und Installationsbreiten angepasst werden.

Als Nachteil bei den bislang bekannten Tragschienen-Bussystemen erweist sich, dass die Busadressierung individuell in den aufgesteckten Geräten und zum Teil durch manuelle Einstellungen an den Geräten selbst erfolgt. Nachträgliche Änderungen oder Erweiterungen der elektrischen Anlage erfordern oftmals in nachteiliger Weise eine Deaktivierung der elektrischen Anlage. Ein Austausch oder eine Erweiterung von Geräten während des Betriebs ist sowohl mechanisch als auch elektrisch nicht immer möglich.

Auch ist bei bestehenden elektrischen Anlagen eine eindeutige Zuordnung der Busadresse zum physikalischen Ort des Gerätes - dem Einbauort im Schaltschrank mit der Einbauposition in der Tragschiene - nur indirekt möglich.

Weiter zeigt die Offenlegungsschrift EP 2 964 005 A2 ein BusverbinderSystem mit Busleiterplatten, die lösbar an ein Gehäuse eines elektrischen Betriebsmittels befestigt sind und durch Zusammenstecken eine langgestreckte Busanordnung in Form einer mechanischen Querverbindung ausbilden, sodass zur Herstellung der elektrischen Kontaktierung zwischen den Betriebsmitteln eine Tragschiene nicht erforderlich ist.

In der DE 10 2010 016 865 A1 ist ein Tragschienenbussystem mit einer Tragschiene und einem in der Tragschiene angeordneten (Stations-)Bus offenbart. Jedes Busglied weist Kontaktstifte sowie eine Leiterplatte auf. Zur Adressierung der auf den Busgliedern angeordneten Module ist eine Reihenschaltung von resistiven Adressenelementen oder von digitalen (Frequenzteiler) Adressenelementen vorgesehen, wobei an einer Rückleitung eine erfasste Adressspannung oder ein digital manipuliertes Signal zur Adressermittlung zurückgeführt wird und jedes Modul eine ihm zugehörige Adressspannung (resistive Adressierung) oder ein Digitalsignal (digitale Manipulation) ermittelt.

Die DE 198 38 493 C1 zeigt eine anreihbare Busschiene zur Anbringung in einer Hutschiene. Die Busschiene ist modular aufgebaut und besteht aus einem länglichen rohrförmigen Gehäuse, das ein oberes Gehäuseteil und ein unteres Gehäuseteil aufweist. Im Inneren des Gehäuses erstreckt sich eine längliche Leiterplatte.

Die EP 2 053 697 A2 beschreibt einen T-förmigen Busverbinder zur Anbringung in einer Trägereinrichtung. Der Busverbinder weist Verbindungseinrichtungen auf zur Verbindung mit benachbarten Busverbindern sowie eine weitere Verbindungseinrichtung zur Verbindung mit einer elektronischen Baugruppe.

Die DE 10 2019 203 521 A1 zeigt ein Verfahren zum Betrieb eines Stromverteilers mit einem ersten Controller und mit einer Anzahl von daran angeschlossenen Anschlussmodulen mit jeweils einem Sockelwiderstand, die eine in Reihe geschaltete Widerstandskette bilden. Der über dem jeweiligen Sockelwiderstand des Anschlussmoduls auftretende Spannungsabfall wird von einem zweiten Controller des Anschlussmoduls erfasst und dient zur Bestimmung einer dem jeweiligen Schutzschalter zugeordneten eindeutigen Adresse. Von dem ersten Controller wird ein bestimmtes Zeitfenster aufgespannt, welches mit einer bestimmten Adresse korrespondiert, sodass eine Kollision der Mitteilung der einzelnen Adressen ausgeschlossen ist.

Der vorliegenden Erfindung liegt somit die Aufgabe zugrunde, die mechanische und elektrische Installation von Tragschienengeräten, insbesondere deren Einbindung in ein Datennetzwerk, flexibel und zuverlässig zu gestalten.

Diese Aufgabe wird in Verbindung mit den Merkmalen des Anspruchs 1 gelöst.

Der Grundgedanke der vorliegenden Erfindung beruht darauf, den Ablauf der Busadress-Zuweisung für das jeweils aufgesteckte Gerät aus dem Gerät in die Tragschienen-Busanordnung zu verlagern.

Dazu ist der Busleiterplatten-Abschnitt der in der Tragschiene befestigten Tragschienen-Busanordnung an der ersten Einbauposition mit einer elektronischen Steuereinheit versehen, welche jeweils über eine in den Busleiterplatten-Abschnitten geführte Detektionsleiterbahn mit dem jeweils nachgeordneten Busleiterplatten-Abschnitt verbunden ist. Die elektronische Steuereinheit erkennt über eine Signalisierung auf der jeweiligen Detektionsleiterbahn sobald ein Gerät auf dem entsprechenden Busleiterplatten-Abschnitt aufgesteckt wird und ordnet dieser Einbaupositionen eine individuelle Busadresse zu. Diese Busadresse wird dem auf der Tragschiene auf dem jeweiligen Busleiterplatten-Abschnitt aufgesteckten Gerät zugewiesen.

Durch die automatische Erkennung der Einbauposition und der mit dieser Einbauposition verknüpften Busadresse erhält das an dieser Einbauposition auf die Tragschiene aufgesteckte Gerät automatisch die eindeutige Busadresse.

In vorteilhafterweise ist somit eine gesonderte, unter Umständen manuell auszuführende, Adresszuweisung für ein aufgestecktes Gerät nicht erforderlich - der für die Adresszuweisung erforderliche Algorithmus, die "Intelligenz", wird aus dem Gerät in die Tragschienen-Busanordnung, verlagert. Sobald ein neues Gerät aufgesteckt oder ein Gerät ausgetauscht wird, wird diesem automatisch und fehlerfrei eine individuelle Busadresse zugewiesen.

Indem im Gegensatz zu den auf dem Markt verfügbaren passiven Verbindungssystemen (konventionelle Tragschienen-Busanordnungen), bei denen die Adresszuweisungs-Mechanismen vollständig oder überwiegend in dem aufsteckbaren Gerät angeordnet sind, befindet sich die Intelligenz zur Busadress-Zuweisung erfindungsgemäß in der Tragschienen-Busanordnung. Daraus resultiert in vorteilhafterweise eine vereinfachte Installation der Geräte verbunden mit geringeren Anforderungen an diese Geräte zur Teilnahme an dem Bussystem, woraus sich wiederum ein Kostenvorteil ergibt.

Bei dieser automatischen Busadress-Zuweisung erkennt die elektronische Steuereinheit unterschiedliche Anlaufverzögerungen des aufgesteckten Gerätes. Die den verschiedenartigen aufsteckbaren Geräten, wie beispielsweise Fehlerstrom-Schutzeinrichtungen (RCDs) oder Leitungsschutzschaltern, eigenen Anlaufverzögerungen beim Einschalten werden bei der Adresszuweisung von der elektronischen Steuereinheit berücksichtigt.

Zudem werden die aufgesteckten Geräte mittels eines in der elektronischen Steuereinheit erzeugten Hardware-Synchronisationssignals synchronisiert.

Die elektronische Steuereinheit ist so ausgelegt, dass die Geräte im laufenden Betrieb aufgesteckt oder ausgetauscht werden können, somit das System nicht heruntergefahren werden muss ("Hot-Plug-Fähigkeit").

In weiterer Ausgestaltung weist die Tragschienen-Busanordnung einen als Anschlusselement ausgebildeten Busleiterplatten-Endabschnitt auf, der mit dem davor befindlichen Busleiterplatten-Abschnitt mechanisch zusammenhängend und elektrisch mit den Busleiterbahnen und einer weiteren Detektionsleiterbahn verbunden ist.

Der in der Tragschiene an einem Ende der Tragschienen-Busanordnung als Anschlusselement ausgebildete Busleiterplatten-Endabschnitt ermöglicht die Verbindung zu einem abgesetzten, nicht in der Tragschiene angeordneten Gerät oder Bedienelement.

Insbesondere ist mittels des Anschlusselements eine Verbindung zu weiteren erfindungsgemäßen Tragschienen-Busanordnungen herstellbar. Dies ermöglicht die Installation einer aus mehreren hintereinander geschalteten Tragschienen-Busanordnungen bestehenden Konfiguration mit Geräten über mehrere, beispielsweise in Schaltschränken untereinander angebrachten Tragschienen hinweg.

Vorzugsweise ist das Anschlusselement als RJ-45-Buchse ausgeführt, die eine Weiterführung der Busleiterbahnen und der weiteren Detektionsleiterbahn über Anschlussleitungen wie Kabelverbindungen ermöglichen.

Weiterhin weist die Tragschienen-Busanordnung eine Sollbruchstelle zwischen den Busleiterplatten-Abschnitten zur Verkürzung der Tragschienen-Busanordnung auf.

Die senkrecht zur der Längsausdehnung der Tragschienen-Busanordnung verlaufende Sollbruchstelle ermöglicht in vorteilhafterweise eine Anpassung der langgestreckten Tragschienen-Busanordnung an die Länge einer vorhandenen Tragschiene.

Weiterhin sind die Kontaktelemente als Kontaktblock ausgeführt. Die Ausführungen aller Kontaktelemente oder eines Teils der Kontaktelemente als Kontaktblock ermöglichen in einfacher Weise eine zuverlässige Kontaktierung des aufgesteckten Gerätes.

Vorzugsweise weisen die Busleiterplatten-Abschnitte (in Längsausdehnung der Tragschienen-Busanordnung) jeweils eine Länge einer genormten Teilungseinheit (TE) auf. Gemäß den Vorschriften zur Elektroinstallation für den Schaltschrankbau (beispielsweise nach der Norm DIN 43880:1988-12) weisen die Busleiterplatten-Abschnitte eine Breite zwischen 17,5 mm und 18,0 mm auf.

Mit Vorteil ist jeweils eine Anzahl der Busleiterbahnen ausgeführt als Energie-Leiterbahnen zur Energieversorgung der aufgesteckten Geräte, als Daten-Leiterbahnen zur Datenübertragung mit den aufgesteckten Geräten und als Signal-Leiterbahnen zur Steuerung der aufgesteckten Geräte.

Insbesondere können daher die aufgesteckten Geräte über die Energie-Leiterbahnen mit Energie versorgt werden. Bei mehreren, über die Anschlusselemente und die Anschlussleitung verbundenen Tragschienen-Busanordnungen kann eine Energiespeisung über jede Tragschienen-Busanordnung erfolgen.

Mit Vorteil weist die Tragschienen-Busanordnung einen selbsterkennenden und reflexionsfreien Abschluss der Tragschienen-Busanordnung auf. Die elektronische Steuereinheit erkennt somit selbstständig, welcher Busleiterplatten-Abschnitt den Abschluss der Tragschienen-Busanordnung bildet und schließt diesen mit einem geeigneten Impedanzwert reflexionsfrei ab (Auto-Terminierung).

Weiter ist der Busleiterplatten-Abschnitt mechanisch so ausgestaltet, dass eine Fehlmontage des aufzusteckenden Gerätes ausgeschlossen ist. Der Busleiterplatten-Abschnitt ist mechanisch so konstruiert, dass das aufzusteckende Gerät nur in der korrekten Einbaulage hinsichtlich der mechanischen Zuordnung zur Einbauposition (verdreh- und verschiebungssicher) unter Sicherstellung der richtigen elektrischen Kontaktierung (verpolungssicher) auf der Hutschiene angebracht werden kann. Die der Erfindung zugrundeliegende Aufgabe wird weiterhin gelöst durch ein Verfahren zur Zuweisung einer Busadresse für ein auf einer Tragschiene aufgestecktes Gerät, gemäß Anspruch 9.

Die Ausführung der zuvor beschriebenen erfindungsgemäßen Tragschienen-Busanordnung beruht auf der in dem unabhängigen Verfahrensanspruch 9 beschriebenen technischen Lehre. Insoweit treffen auch die vorgenannten technischen Wirkungen und die daraus entstehenden verfahrenstechnischen Vorteile auf die Verfahrensmerkmale zu. Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1**: eine erfindungsgemäße Tragschienen-Busanordnung in einer Tragschiene installiert,
- **Fig. 2**: eine erfindungsgemäße Tragschienen-Busanordnung mit aufgestecktem Gerät in einer Tragschiene installiert,
- **Fig. 3**: eine funktionale Darstellung der Busadress-Zuweisung und
- **Fig. 4**: eine funktionale Darstellung der Busadress-Zuweisung bei einer langen Tragschiene.

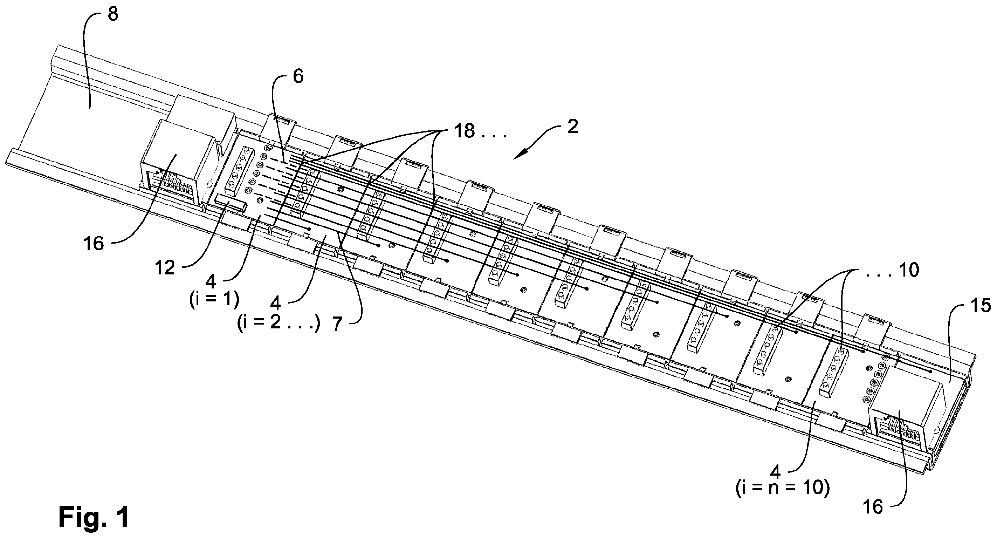

**Fig. 1** zeigt eine perspektivische Darstellung einer erfindungsgemäßen, in einer Tragschiene 8 installierten, Tragschienen-Busanordnung 2.

Die Tragschienen-Busanordnung 2 besteht aus einer Anzahl von vorzugsweise n=10 Busleiterplatten-Abschnitten 4, die in der Tragschiene 8 angeordnet sind.

Die mechanische Ausgestaltung der Tragschienen-Busanordnung 2 lässt nur eine eindeutige Einbaulage in der Tragschiene 8 zu, sodass eine Fehlmontage ausgeschlossen ist.

Die Busleiterplatten-Abschnitte 4 sind jeweils mit - im vorliegenden Beispiel mit m=5 - Busleiterbahnen 6 untereinander verbunden (die Busleiterbahnen 6 sind nur zwischen den Busleiterplatten-Abschnitten 4 an den Einbaupositionen eins und zwei angedeutet, sonst verdeckt).

Der an der Einbauposition i=1 befindliche Busleiterplatten-Abschnitt 4 weist eine elektronische Steuereinheit 12 auf, die bevorzugt als Mikrocontroller ausgeführt ist.

Ausgehend von dem mit der elektronische Steuereinheit 12 besetzten Busleiterplatten-Abschnitt 4 an der Einbauposition i=1 führt jeweils eine Detektionsleiterbahn 7 (schematisch dargestellt) zu dem jeweiligen nachgeordneten Busleiterplatten-Abschnitt 4 sowie eine weitere Detektionsleiterbahn 7 zu einem als Anschlusselement 16 ausgebildeten Busleiterplatten-Endabschnitt 15.

Bei dem vorzugsweise als RJ-45-Buchse ausgeführten Anschlusselement 16 zeigt die Einstecköffnung nach unten (bezogen auf die Einbaulage an der Tragschiene 8), um zu verhindern, dass während der Montage mögliche Kleinteile, wie beispielsweise abgetrennte Leitungsisolierungen, in die Buchse gelangen.

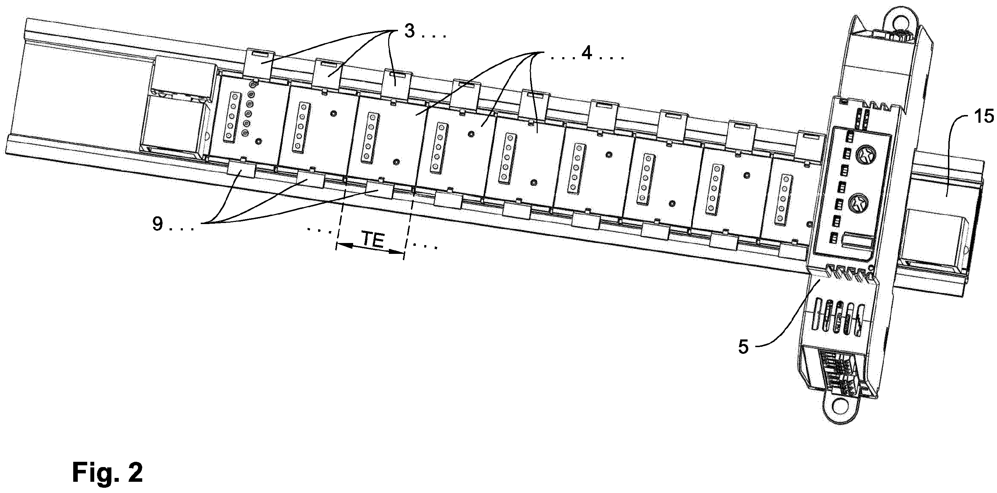

Die Busleiterplatten-Abschnitte 4 sind jeweils mit - im vorliegenden Beispiel mit k=5 - Kontaktelementen 10 in Form eines Kontaktblockes versehen, um das jeweilige aufgesteckte Gerät 5 (Fig. 2) zu kontaktieren.

An beiden Enden der Tragschienen-Busanordnung 2 ist das Anschlusselement 16 auf dem Busleiterplatten-Endabschnitt 15 mit dem davor - im vorliegenden Beispiel an der Einbauposition i=n=10 - befindlichen Busleiterplatten-Abschnitt 4 mechanisch zusammenhängend und elektrisch über die fünf Busleiterbahnen 6 und der weiteren Detektionsleiterbahn 7 verbunden in der Tragschiene 8 angeordnet.

**Fig. 2** zeigt die erfindungsgemäße Tragschienen-Busanordnung 2 mit dem an der Einbauposition i=10 aufgesteckten Gerät 5.

Die Breite der jeweiligen Busleiterplatten-Abschnitte 4 beträgt normgemäß eine Teilungseinheit TE.

Jeder Busleiterplatten-Abschnitt 4 weist an seiner Oberkante (bezogen auf seine Einbaulage an der Tragschiene 8) einen Rasthaken 3 sowie an seiner Unterkante eine Auflage 9 auf, sodass eine Anbringung nur in der dargestellten vertikalen Ausrichtung möglich ist, da der Busleiterplatten-Abschnitt 4 bei entgegengesetzter vertikaler Ausrichtung infolge der Schwerkraft keinen Halt finden würde.

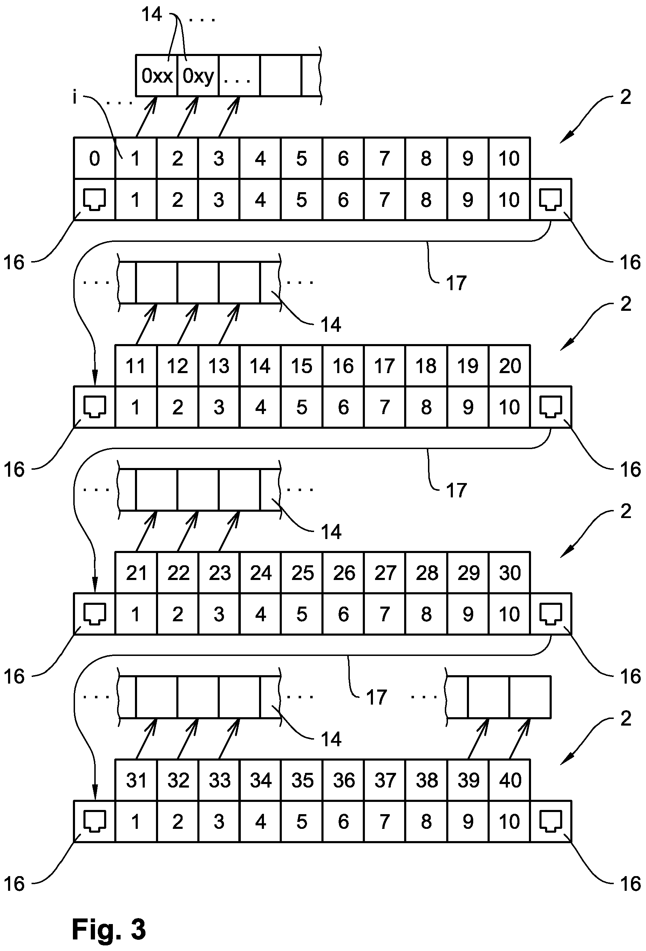

**Fig. 3** zeigt eine funktionale Darstellung der Busadress-Zuweisung mit der Zuordnung der Einbauposition i zu der Busadresse 14. In diesem Beispiel erstreckt sich die gesamte Tragschienen-Busanordnung über mehrere Tragschienen 8 (Fig. 1) mit jeweils 10 Einbaupositionen i, wobei in jeder Tragschiene 8 eine vollständige Tragschienen-Busanordnung 2 installiert ist.

Die einzelnen Tragschienen-Busanordnungen 2 sind miteinander über ein Anschlusselement 16 und eine Anschlussleitung 17 verbunden. In dieser Konstellation wird die Einbauposition i bezogen auf die gesamte Tragschienen-Busanordnung fortlaufend durchnummeriert (absolute Einbauposition). Die auf die jeweilige Tragschiene 8 bezogene Position ist für jede Tragschiene 8 mit einer neu startenden Nummerierung belegt.

Jeder absoluten Einbauposition i wird eine individuelle Busadresse 14 zugeordnet, die dem an der jeweiligen (absoluten) Einbauposition i und der damit korrespondierenden Position auf der jeweiligen Tragschiene 8 aufgesteckten Gerät 5 (Fig. 2) automatisch zugewiesen wird.

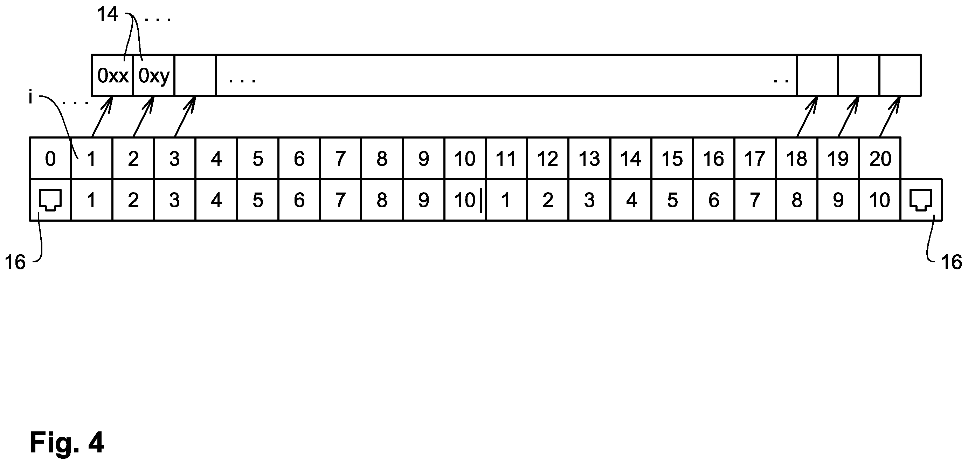

**Fig. 4** zeigt eine funktionale Darstellung der Busadress-Zuweisung bei einer langen Tragschiene.

In dieser Ausgestaltung sind zwei Tragschienen-Busanordnungen 2 unmittelbar als eine zusammenhängende Tragschienen-Busanordnung auf einer langen Tragschiene 8 (Fig. 1) ausgeführt. Die zwei jeweils vollständigen Tragschienen-Busanordnungen 2 sind nicht über das Anschlusselement 16 mit der Anschlussleitung 17, sondern unmittelbar wie die Busleiterplatte-Abschnitte 4 (Fig. 1) untereinander mechanisch und elektrisch verbunden.

## Patentansprüche

1. Tragschienen-Busanordnung, bestehend aus einer Anzahl von n mechanisch zusammenhängenden und elektrisch über Busleiterbahnen (6) verbundenen in einer Tragschiene (8) nebeneinander an Einbaupositionen i (1≤i≤n) installierbaren Busleiterplatten-Abschnitten (4), die jeweils k Kontaktelemente (10) zur Kontaktierung eines an der jeweiligen Einbauposition i auf die Tragschiene (8) aufgesteckten Gerätes (5) aufweisen, wobei eine elektronische Steuereinheit (12) auf dem Busleiterplatten-Abschnitt (4) an der ersten Einbauposition i=1 angeordnet ist und von dem Busleiterplatten-Abschnitt (4) an der ersten Einbauposition i=1 zu jedem nachgeordneten Busleiterplatten-Abschnitt (4) jeweils eine separate Detektionsleiterbahn (7) führt, wobei die elektronische Steuereinheit (12) mittels einer Signalisierung auf der jeweiligen Detektionsleiterbahn (7) erkennt, ob an der jeweiligen Einbauposition i ein Gerät (5) aufgesteckt ist, und wobei die elektronische Steuereinheit so ausgeführt ist, dass der jeweiligen Einbauposition i automatisch eine Busadresse (14) zugeordnet ist, welche dem auf dem jeweiligen Busleiterplatten-Abschnitt (4) an der jeweiligen Einbauposition i auf die Tragschiene (8) aufgesteckten Gerät (5) zugewiesen ist.

2. Tragschienen-Busanordnung nach Anspruch 1, umfassend einen als Anschlusselement (16) ausgebildeten Busleiterplatten-Endabschnitt (15), der mit dem davor befindlichen Busleiterplatten-Abschnitt (4) mechanisch zusammenhängend und elektrisch mit den Busleiterbahnen (6) und einer weiteren Detektionsleiterbahn (7) verbunden ist.

3. Tragschienen-Busanordnung nach Anspruch 1 oder 2, umfassend eine Sollbruchstelle (18) zwischen den Busleiterplatten-Abschnitten (4) zur Verkürzung der Tragschienen-Busanordnung (2).

4. Tragschienen-Busanordnung nach einem der Ansprüche 1 bis 3, wobei die Kontaktelemente (10) als Kontaktblock ausgeführt sind.

5. Tragschienen-Busanordnung nach einem der Ansprüche 1 bis 4, wobei der Busleiterplatten-Abschnitt (4) eine Länge einer genormten Teilungseinheit (TE) aufweist.

6. Tragschienen-Busanordnung nach einem der Ansprüche 1 bis 5, wobei jeweils eine Anzahl der Busleiterbahnen (6) ausgeführt ist als Energie-Leiterbahnen zur Energieversorgung der aufgesteckten Geräte ausgeführt sind, als Daten-Leiterbahnen zur Datenübertragung mit den aufgesteckten Geräten und als Signal-Leiterbahnen zur Steuerung der aufgesteckten Geräte (5).

7. Tragschienen-Busanordnung nach einem der Ansprüche 1 bis 6, umfassend einen selbsterkennenden und reflexionsfreien Abschluss der Tragschienen-Busanordnung (2).

8. Tragschienen-Busanordnung nach einem der Ansprüche 1 bis 7, wobei der Busleiterplatten-Abschnitt (4) mechanisch so ausgestaltet ist, dass eine Fehlmontage des aufzusteckenden Gerätes (5) ausgeschlossen ist.

9. Verfahren zur Zuweisung einer Busadresse für ein auf einer Tragschiene (8) aufgestecktes Gerät (5) mittels einer erfindungsgemäßen Tragschienen-Busanordnung nach den Ansprüchen 1 bis 7, umfassend die Verfahrensschritte:
Erkennen, ob an der jeweiligen Einbauposition i das Gerät (5) aufgesteckt ist mittels einer Signalisierung auf der jeweiligen Detektionsleiterbahn (7) durch die elektronische Steuereinheit (12) und der von dem Busleiterplatten-Abschnitt (4) an der ersten Einbauposition i=1 zu jedem weiteren Busleiterplatten-Abschnitt (4) separat führenden Detektionsleiterbahn (7),
automatisches Zuordnen der Busadresse (14) zu der jeweiligen Einbauposition i mittels der elektronischen Steuereinheit (12), und Zuweisen der Busadresse (14) an das auf dem jeweiligen Busleiterplatten-Abschnitt (4) an der jeweiligen Einbauposition i auf die Tragschiene aufgesteckte Gerät (5) mittels der elektronischen Steuereinheit (12).

## Claims

1. A carrier-rail bus assembly which consists of a number of n mechanically contiguous bus-circuit-plate sections (4), which are electrically connected via bus circuit paths (6), are installed next to each other in installation positions i (1 ≤ i ≤ n) and each have k contacting elements (10) for being electrically contacted with an apparatus (5) inserted on the carrier rail (8) in respective installation position i,
wherein
an electronic control unit (12) is disposed on the bus-circuit-plate section (4) in first installation position i = 1 and a separate detection circuit path (7) leads to every downstream bus-circuit-plate section (4) from the bus-circuit-plate section (4) in first installation position i = 1, the electronic control unit (12) detecting by means of a signaling on the detection circuit path (7) whether an apparatus (5) is inserted in installation position i in question, and the electronic control unit being configured such that respective installation position i is automatically allotted to a bus address (14), which is assigned to the apparatus (5) inserted on the carrier rail (8) on the respective bus-circuit-plate section (4) in respective installation position i.

2. The carrier-rail bus assembly according to claim 1,
comprising
a bus-circuit-plate end section (15), which is realized as a connection element (16) and is electrically connected to the bus circuit paths (6) and another detection circuit path (7) so as to be mechanically contiguous with the preceding bus-circuit-plate section (4).

3. The carrier-rail bus assembly according to claim 1 or 2,
comprising
a predetermined breaking point (18) between the bus-circuit-plate sections (4) for shortening the carrier-rail bus assembly (2).

4. The carrier-rail bus assembly according to any one of the claims 1 to 3,
wherein
the contacting elements (10) are realized as contacting block.

5. The carrier-rail bus assembly according to any one of the claims 1 to 4,
wherein
the bus-circuit-path sections (4) are as long as a standardized space unit (TE).

6. The carrier-rail bus assembly according to any one of the claims 1 to 5,
wherein
a number of bus-circuit paths (6) are each realized as energy circuit paths for supplying energy to the inserted apparatus, as data circuit paths for transferring data using the inserted apparatus and as signal circuit paths for controlling the inserted apparatus (5).

7. The carrier-rail bus assembly according to any one of the claims 1 to 6,
comprising
a self-detecting and reflection-free termination of the carrier-rail bus assembly (2).

8. The carrier-rail bus assembly according to any one of the claims 1 to 7,
wherein
the bus-circuit-plate section (4) is mechanically designed in such a manner that the apparatus (5) to be inserted cannot be wrongly mounted.

9. A method for assigning a bus address for an apparatus (5), which is inserted on a carrier rail (8), by means of a carrier-rail bus assembly according to the claims 1 to 7 of the invention, the method comprising the following steps:
detecting whether the apparatus (5) is inserted in respective installation position i by means of a signaling on the detection circuit path (7) via the electronic control unit (12) and by means of the detection circuit path (7), which separately leads to each further bus-circuit-plate section (4) from the bus-circuit-plate section (4) in first installation position i = 1;
automatically allotting the bus address (14) to respective installation position i by means of the electronic control unit (12); and
assigning the bus address (14) to the apparatus (5), which is inserted on the carrier rail on the respective bus-circuit-plate section (4) in respective installation position i, by means of the electronic control unit (12).

## Revendications

1. Agencement de bus d'un profilé support qui se compose d'un nombre n de parties (4) de platine bus mécaniquement contiguës, qui sont reliées électriquement à l'intermédiaire des trajets (6) de circuit bus, sont installées les unes à côté des autres dans des positions d'installation i (1 ≤ i ≤ n) et ayant chacune k éléments de contact (10) destinés à être mis en contact électrique avec un appareil (5) inséré sur le profilé support (8) dans la position d'installation respective i,
dans lequel
une unité de contrôle (12) électronique est disposée sur la partie (4) de platine bus dans la première position d'installation i = 1 et un trajet (7) de circuit de détection séparément mène à chaque partie (4) de platine bus en aval à partir de la partie (4) de platine bus dans la première position d'installation i = 1, l'unité de contrôle (12) électronique détectant au moyen d'une signalisation sur le trajet (7) de circuit de détection si un appareil (5) est inséré dans la position d'installation i en question, et l'unité de contrôle électronique étant configurée de telle sorte que la position d'installation i respective est automatiquement attribuée à une adresse bus (14), qui est attribuée à l'appareil (5) inséré sur le support profilé (8) sur la partie (4) de platine bus respective dans la position d'installation i respective.

2. Agencement de bus du profilé support selon la revendication 1,
comprenant
une extrémité (15) d'une platine bus, qui est réalisée sous la forme d'un élément de connexion (16) et est reliée électriquement aux trajets (6) de circuit bus et à un autre trajet (7) de circuit de détection de manière à être mécaniquement contiguë à la partie (4) de platine bus précédente.

3. Agencement de bus du profilé support selon la revendication 1 ou la revendication 2,
comprenant
un point de rupture (18) entre les parties (4) de platine bus pour raccourcir l'agencement de bus (2) du profilé support.

4. Agencement de bus du profilé support selon l'une quelconque des revendications 1 à 3,
dans lequel
les éléments de contact (10) sont réalisés sous forme de bloc de contact.

5. Agencement de bus du profilé support selon l'une quelconque des revendications 1 à 4,
dans lequel
les parties (4) de platine bus ont une longueur égale à une unité de division (TE) normalisée.

6. Agencement de bus d'un profilé support selon l'une quelconque des revendications 1 à 5,
dans lequel
un certain nombre de trajets (6) de circuit bus sont chacun réalisés comme trajets de circuit d'énergie pour fournir de l'énergie à l'appareil inséré, comme trajets de circuit de données pour transférer des données à l'aide des appareils insérés et comme trajets de circuit de signal pour commander les appareils (5) insérés.

7. Agencement de bus d'un profilé support selon l'une quelconque des revendications 1 à 6,
comprenant
une terminaison auto-détectable et sans réflexion de l'agencement de bus (2) du profilé support.

8. Agencement de bus du profilé support selon l'une quelconque des revendications 1 à 7,
dans lequel
la partie (4) de platine bus est conçue mécaniquement de telle manière qu'un montage incorrect de l'appareil (5) à insérer est evité.

9. Procédé d'attribution d'une adresse bus à un appareil (5) inséré sur un profilé support (8) au moyen d'un agencement de bus d'un support profilé selon l'une quelconque des revendications 1 à 7 de l'invention, le procédé comprenant les étapes suivantes :
la détection si l'appareil (5) est inséré dans la position d'installation i respective au moyen d'une signalisation sur le trajet (7) de circuit de détection à l'intermédiaire de l'unité de contrôle (12) électronique et au moyen du trajet (7) de circuit de détection, qui séparément mène à chaque autre partie (4) de platine bus à partir de la partie (4) de platine bus dans la première position d'installation i = 1 ;
l'attribution automatique de l'adresse bus (14) à la position d'installation i respective au moyen de l'unité de contrôle électronique (12) ; et
l'attribution de l'adresse bus (14) à l'appareil (5), qui est inséré sur le profilé support sur la partie (4) de platine bus respective dans la position d'installation i respective, au moyen de l'unité de contrôle (12) électronique.
